(19) **Europäisches Patentamt / European Patent Office / Office européen des brevets**

(11)  **EP 2 664 940 B1**

(12)  # EUROPEAN PATENT SPECIFICATION

(45) Date of publication and mention
of the grant of the patent:
**12.02.2020  Bulletin 2020/07**

(21) Application number: **11855718.0**

(22) Date of filing: **28.12.2011**

(51) Int Cl.:
**G01R 33/09** *(2006.01)*          **H01L 43/08** *(2006.01)*

(86) International application number:
**PCT/JP2011/080363**

(87) International publication number:
**WO 2012/096132 (19.07.2012 Gazette 2012/29)**

(54) **MAGNETIC SENSOR**

MAGNETISCHER SENSOR

CAPTEUR MAGNÉTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.01.2011  JP 2011004634
07.03.2011  JP 2011048565**

(43) Date of publication of application:
**20.11.2013  Bulletin 2013/47**

(73) Proprietor: **Alps Alpine Co., Ltd.
Tokyo
145-8501 (JP)**

(72) Inventors:
• **OBANA, Masayuki**
  **Tokyo 145-8501 (JP)**
• **ANDO, Hideto**
  **Tokyo 145-8501 (JP)**

(74) Representative: **Schmitt-Nilson Schraud Waibel
Wohlfrom
Patentanwälte Partnerschaft mbB
Pelkovenstraße 143
80992 München (DE)**

(56) References cited:
**WO-A1-2009/048018          WO-A1-2009/151024
WO-A1-2011/089978          US-A1- 2004 137 275
US-A1- 2010 259 257**

**Description**

TECHNICAL FIELD

The present invention relates to a magnetic sensor with high resistance to a strong magnetic field or a disturbance magnetic field.

BACKGROUND ART

For example, a magnetic sensor using a magneto-resistive effect element can be used as a geomagnetic sensor which is incorporated into a portable apparatus, such as a mobile phone, and detects geomagnetism.

However, in a magnetic sensor including a bias layer for supplying a bias magnetic field to an element portion, when a very strong magnetic field, for example, a strong magnetic field of about several thousands of Oe is applied from the outside, an output (midpoint potential difference) is changed after the applied magnetic field is removed. This is because the magnetization of the bias layer is likely to be broken or changed by the strong magnetic field.

In addition, it is important to improve resistance to the disturbance magnetic field in a direction orthogonal to the detection magnetic field.

CITATION LIST

PATENT LITERATURE

US 2010/259257 A1 discloses a magnetic sensor and a magnetic sensor module. Magnetoresistive effect elements are provided with an element unit having an elongated shape in which an element length L1 is formed to be longer than an element width W1. The element unit has a fixed magnetic layer and a free magnetic layer laminated via a non-magnetic layer on the fixed magnetic layer. A magnetism direction of the fixed magnetic layer faces an element width direction (Y direction) of a sensitivity axis direction. First soft magnetic bodies formed to have a width size W2 and a length size L2 are arranged in a noncontact manner on both lateral sides of the magnetoresistive effect element. The length size L2 is longer than the element length L1, and the first soft magnetic body has an extension part extending in an element length direction from both sides in the element length direction of the element unit.

The present invention relates to a magnetic sensor in accordance with the appended claims.

> PTL 1: Japanese Unexamined Patent Application Publication No. 7-325138
> PTL 2: Japanese Unexamined Patent Application Publication No. 9-105630
> PTL 3: Japanese Unexamined Patent Application Publication No. 7-324933
> PTL 4: Japanese Unexamined Patent Application Publication No. 7-324934

DISCLOSURE OF THE INVENTION

PROBLEMS TO BE SOLVED BY THE INVENTION

The invention has been made in view of the above-mentioned problems and an object of the invention is to provide a magnetic sensor capable of improving resistance to a strong magnetic field or a disturbance magnetic field.

MEANS FOR SOLVING THE PROBLEMS

According to an aspect of the invention, a magnetic sensor includes a plurality of element portions each of which is formed by laminating a magnetic layer and a non-magnetic layer and has a magneto-resistive effect, bias layers that are provided on both sides of each element portion in a first horizontal direction, and soft magnetic bodies that are provided on both sides of each element portion in a second horizontal direction orthogonal to the first horizontal direction so as not to contact each element portion and each bias layer. A sensitivity axis direction of each element portion is the second horizontal direction. A magnetization direction of each bias layer is the second horizontal direction. Each bias layer is configured such that a bias magnetic field is supplied in the first horizontal direction from each bias layer to each element portion. Each soft magnetic body is configured such that, when an external magnetic field is applied in the first horizontal direction, the soft magnetic bodies which are provided on both sides of each element portion in the second horizontal direction convert the external magnetic field in a horizontal direction different from the first horizontal direction and supply the external magnetic field to the element portion. The plurality of element portions are arranged in the first horizontal direction with a gap therebetween and the bias layers connected to the element portions which are adjacent to each other in the first horizontal direction are connected to each other by a conductive layer, thereby forming an element-connected body. A plurality of the element-connected bodies are arranged in the second horizontal direction with a gap therebetween and end portions of the element-connected bodies are connected to each other in a meander shape by the conductive layer. A predetermined gap T1 is provided between each element portion and each of the soft magnetic bodies which are provided on both sides of each element portion in the second horizontal direction in a plan view. The bias layer does not overlap a virtual line which connects edge portions where the distance between the soft magnetic bodies is the shortest in a straight line in a plan view and the virtual line passes through the element portion disposed between the bias layers. The bias layer is not provided between the soft magnetic bodies of the element-connected bodies which are adjacent to each other in the second horizontal direction. According to this structure, it is possible to improve resistance to a strong magnetic field.

In the above-mentioned aspect of the invention, the soft magnetic body may include a Y1-side end portion which is provided on a Y1 side of one of the element portions, which are adjacent to each other in each element-connected body, in the second horizontal direction, a Y2-side end portion which is provided on a Y2 side of the other element portion opposite to the Y1 side, and a connection portion which connects the Y1-side end portion and the Y2-side end portion. According to this structure, it is possible to simply and appropriately arrange each soft magnetic body relative to the element portion. In addition, it is possible to convert the external magnetic field in the horizontal direction different from the second horizontal direction and appropriately apply the converted magnetic field to each element portion.

In the above-mentioned aspect of the invention, the connection portion may be provided so as to be inclined with respect to both the first horizontal direction and the second horizontal direction.

In the above-mentioned aspect of the invention, each soft magnetic body may be configured such that a magnetic path for a disturbance magnetic field applied in the second horizontal direction can be formed between the soft magnetic bodies provided in the adjacent element-connected bodies. In this case, the connection portion of one of the soft magnetic bodies provided in the adjacent element-connected bodies may be disposed on an extension line of the connection portion of the other soft magnetic body.

In the above-mentioned aspect of the invention, a leading end of the Y1-side end portion of one of the soft magnetic bodies which are provided on both sides of each element portion in the second horizontal direction and a leading end of the Y2-side end portion of the other soft magnetic body may be bent toward the element portion in a plan view, and the leading end of the one soft magnetic body and the leading end of the other soft magnetic body may face each other in the second horizontal direction with a gap T2 therebetween. According to this structure, it is possible to concentrate the flow of magnetic flux from the soft magnetic body to the element portion (effectively facilitate the inflow of magnetic flux) and thus improve sensitivity (output) .

In the above-mentioned aspect of the invention, the arrangement of the element portion, the bias layer, and the soft magnetic body may be the same in each element-connected body.

In the above-mentioned aspect of the invention, each element-connected body may include a first element portion and a second element portion which are adjacent to each other in the first horizontal direction, and the structure of the bias layers which are provided on both sides of the first element portion in the first horizontal direction is different from the structure of the bias layers which are provided on both sides of the second element portion in the first horizontal direction such that the direction of a first bias magnetic field applied to the first element portion is opposite to the direction of a second bias magnetic field applied to the second element portion.

In the above-mentioned aspect of the invention, a magneto-resistive effect element forming region may be divided into four regions in the first horizontal direction and the second horizontal direction. A first magneto-resistive effect element, a second magneto-resistive effect element, a third magneto-resistive effect element, and a fourth magneto-resistive effect element each of which includes the element portion, the bias layer, and the soft magnetic body and which form a bridge circuit may be formed in the four regions, respectively. A change in electric resistance with respect to the external magnetic field applied in the first horizontal direction may be the same in the first magneto-resistive effect element and the fourth magneto-resistive effect element. The change in electric resistance with respect to the external magnetic field applied in the first horizontal direction may be the same in the second magneto-resistive effect element and the third magneto-resistive effect element, and may be different in the first magneto-resistive effect element and the fourth magneto-resistive effect element. The structure of each element portion and each bias layer may be the same in the magneto-resistive effect elements. The soft magnetic bodies in the first magneto-resistive effect element and the fourth magneto-resistive effect element may have the same structure. The soft magnetic bodies in the second magneto-resistive effect element and the third magneto-resistive effect element may have the same structure. The soft magnetic bodies in the first magneto-resistive effect element and the fourth magneto-resistive effect element may be different from each other such that the conversion direction of the magnetic field applied to each element portion in the first magneto-resistive effect element is opposite to that of the magnetic field applied to each element portion in the fourth magneto-resistive effect element.

In the above-mentioned aspect of the invention, the soft magnetic bodies forming the first magneto-resistive effect element and the fourth magneto-resistive effect element and the soft magnetic bodies forming the second magneto-resistive effect element and the third magneto-resistive effect element may be symmetric with respect to a line along the second horizontal direction.

According to another aspect of the invention, a magnetic sensor includes a plurality of element portions each of which is formed by laminating a magnetic layer and a non-magnetic layer and has a magneto-resistive effect, bias layers that are provided on both sides of each element portion in a first horizontal direction, and soft magnetic bodies that are provided on both sides of each element portion in a second horizontal direction orthogonal to the first horizontal direction so as not to contact each element portion and each bias layer. A sensitivity axis direction of each element portion is the second horizontal direction. A magnetization direction of each bias layer is the second horizontal direction. Each bias layer is arranged such that a bias magnetic field is supplied in the first horizontal direction from each bias layer to each element portion. Each soft magnetic body is arranged such that, when an external magnetic field is applied in the first horizontal direction, the soft magnetic bodies which are provided on both sides of each element portion in the second horizontal direction convert the external magnetic field in a horizontal direction different from the first horizontal direction and supply the external magnetic field to the element portion. The plurality of element portions are arranged in the first horizontal direction with a gap therebetween and the bias layers provided in the element portions which are adjacent to each other in the first horizontal direction are connected to each other by a conductive layer, thereby forming an element-connected body. A plurality of the element-connected bodies are arranged in the second horizontal direction with a gap therebetween and end portions of the element-connected bodies are connected to each other in a meander shape by the conductive layer. The soft magnetic body includes a Y1-side end portion which is provided on a Y1 side of one of the element portions, which are adjacent to each other in each element-connected body, in the second horizontal direction, a Y2-side end portion which is provided on a Y2 side of the other element portion opposite to the Y1 side, and a connection portion which connects the Y1-side end portion and the Y2-side end portion. Each soft magnetic body is configured such that a magnetic path for a disturbance magnetic field applied in the second horizontal direction can be formed between the soft magnetic bodies provided in the adjacent element-connected bodies. According to this structure, it is possible to improve resistance to a disturbance magnetic field.

In the above-mentioned aspect of the invention, the connection portion may be arranged so as to be inclined with respect to both the first horizontal direction and the second horizontal direction.

The connection portion of one of the soft magnetic bodies provided in the adjacent element-connected bodies may be disposed on an extension line of the connection portion of the other soft magnetic body.

In the above-mentioned aspect of the invention, a leading end of the Y1-side end portion of one of the soft magnetic bodies which are provided on both sides of each element portion in the second horizontal direction and a leading end of the Y2-side end portion of the other soft magnetic body may be bent toward the element portion in a plan view. The leading end of the one soft magnetic body and the leading end of the other soft magnetic body may face each other in the second horizontal direction with a gap T2 therebetween.

ADVANTAGEOUS EFFECTS OF THE INVENTION

According to the magnetic sensor of the invention, it is possible to improve resistance to a strong magnetic field or resistance to a disturbance magnetic field resistance, or resistance to a strong magnetic field and resistance to a disturbance magnetic field.

BRIEF DESCRIPTION OF THE DRAWINGS

Fig. 1 is a schematic view (plan view) illustrating a magnetic sensor according to an embodiment;
Fig. 2 is a partially enlarged plan view illustrating a region A shown in Fig. 1;
Fig. 3 is a partially enlarged plan view illustrating a region B shown in Fig. 1;
Fig. 4 is a partially enlarged plan view illustrating a region C shown in Fig. 1;
Fig. 5 is a partially enlarged longitudinal sectional view illustrating an element portion taken along the height direction;
Fig. 6 is a partially enlarged longitudinal sectional view taken along the line D-D of Fig. 2 in the height direction;

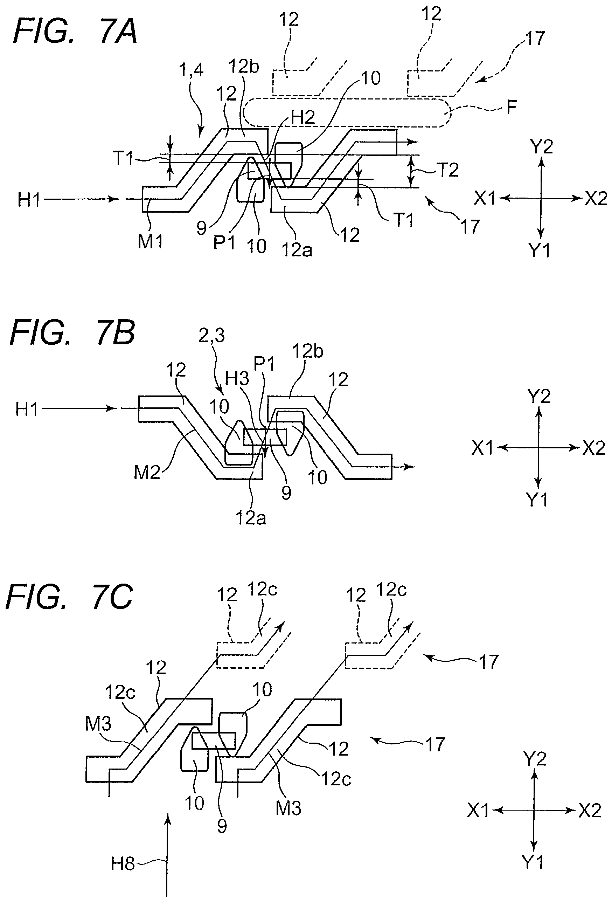

Fig. 7(a) is a plan view illustrating only a unit of an element portion, bias layers, and soft magnetic bodies forming a first magneto-resistive effect element and a fourth magneto-resistive effect element and particularly shows a magnetic path when an external magnetic field H1 is applied, Fig. 7 (b) is a plan view illustrating only a unit of an element portion, bias layers, and soft magnetic bodies forming a second magneto-resistive effect element and a third magneto-resistive effect element and particularly shows a magnetic path when the external magnetic field H1 is applied, and Fig. 7(c) is a plan view illustrating only a unit of the element portion, the bias layers, and the soft magnetic bodies forming the first magneto-resistive effect element and the fourth magneto-resistive effect element and particularly shows a magnetic path when a disturbance magnetic field H8 is applied;

Fig. 8 is a partially enlarged plan view illustrating the structure of a magnetic sensor according to a comparative example;

Fig. 9 is a graph illustrating the relationship between the magnetic field applied in a sensitivity axis direction and an output variation in the magnetic sensor according to the embodiment shown in Figs. 2 to 4 and Fig. 7 and the magnetic sensor in the comparative example;

Fig. 10 is a graph illustrating the relationship between the magnetic field applied in a non-sensitivity axis direction and an output variation in the magnetic sensor according to the embodiment shown in Figs. 2 to 4 and Fig. 7 and the magnetic sensor in the comparative example;

Fig. 11 is a graph illustrating a change in offset magnetic field sensitivity in the magnetic sensor according to the embodiment shown in Figs. 2 to 4 and Fig. 7 and the magnetic sensor in the comparative example;

Fig. 12 is a partially enlarged plan view illustrating a magnetic sensor according to an embodiment different from that shown in Figs. 2 to 4;

Fig. 13 is a partially enlarged plan view illustrating an element portion, bias layers, and soft magnetic bodies shown in Fig. 12; and

Fig. 14 is a graph illustrating the relationship between the gap between the soft magnetic bodies and sensitivity (output) in the magnetic sensor according to the embodiment shown in Figs. 2 to 4 and Fig. 7 and the magnetic sensor shown in Figs. 12 and 13.

## BEST MODE FOR CARRYING OUT THE INVENTION

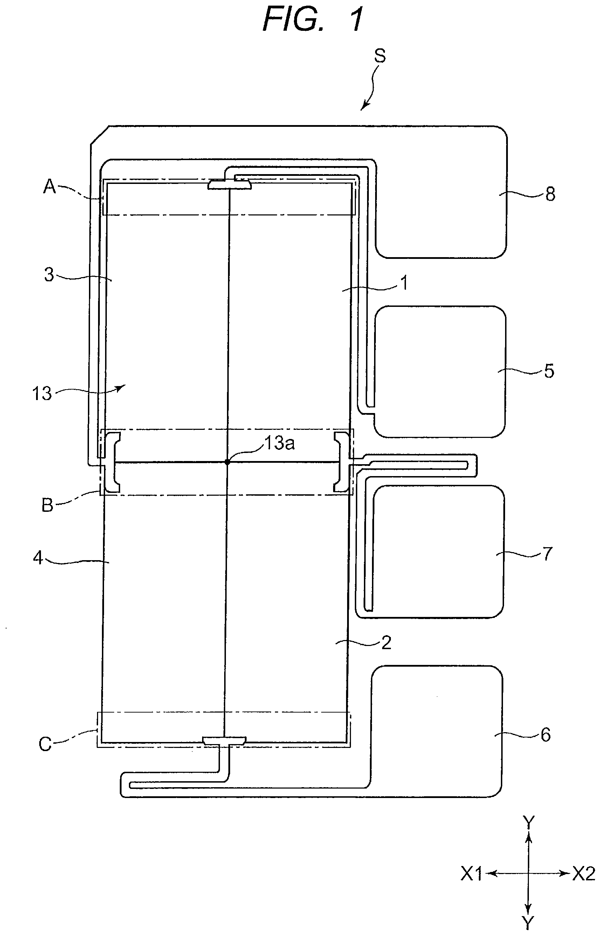

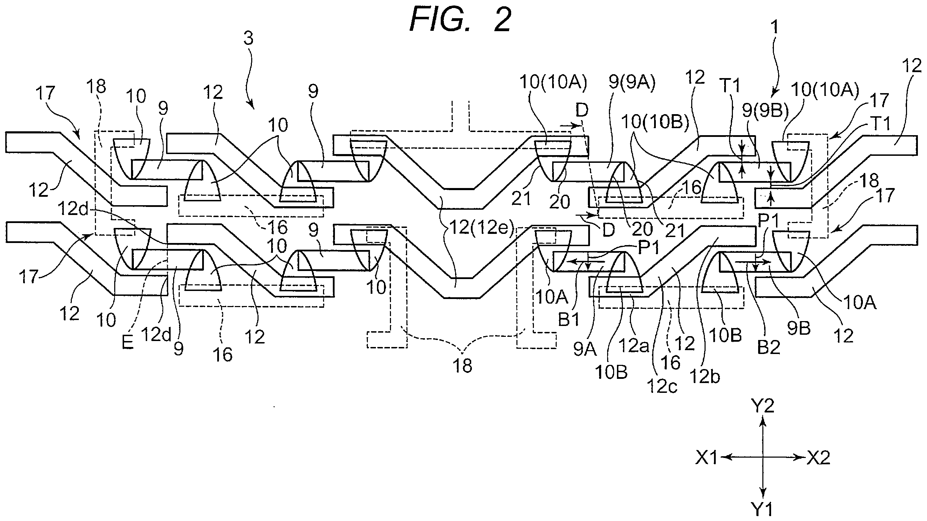

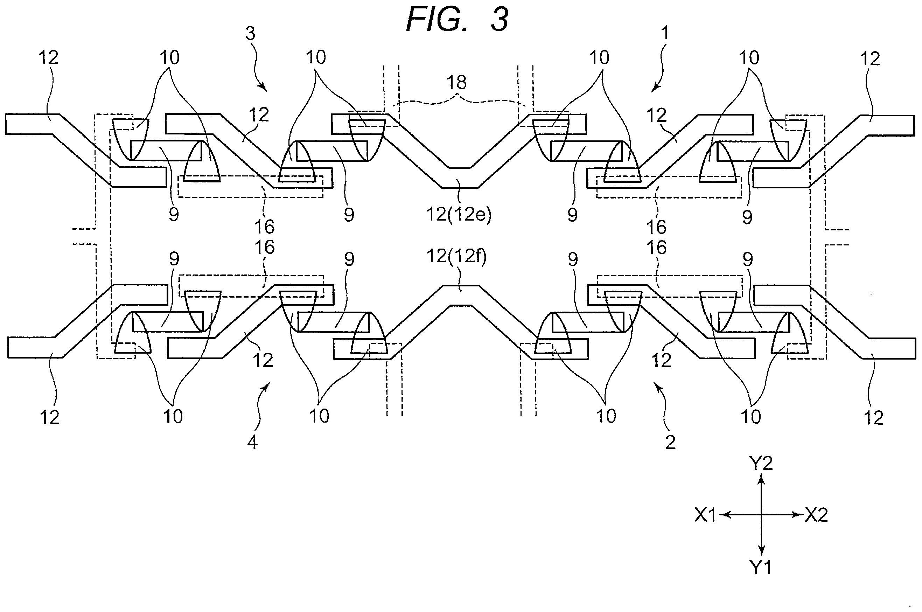

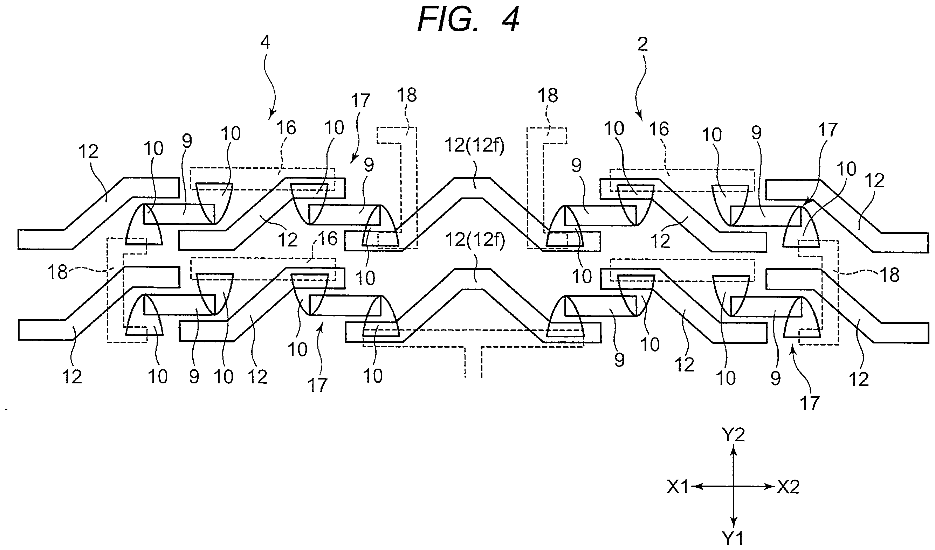

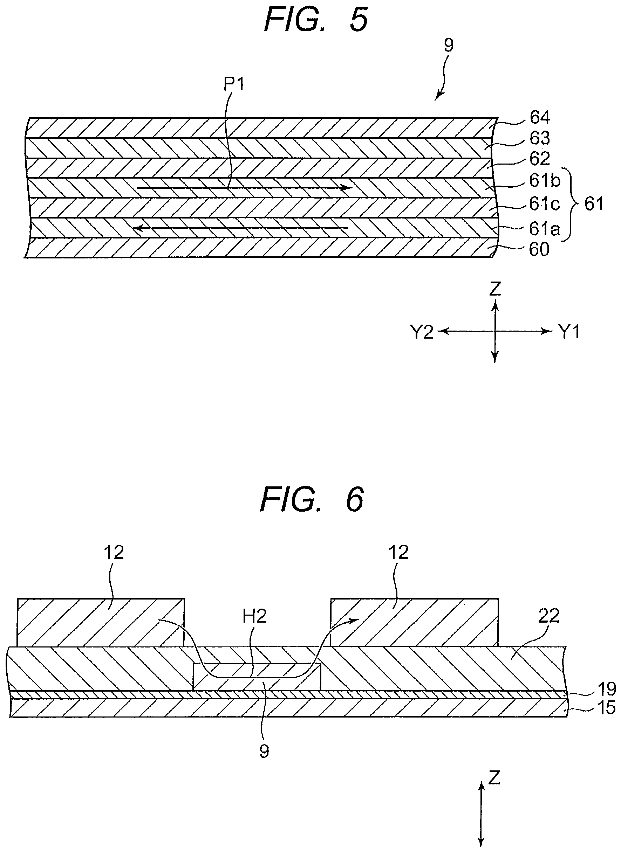

Fig. 1 is a schematic diagram (plan view) illustrating a magnetic sensor according to an embodiment. Fig. 2 is a partially enlarged plan view illustrating a region A shown in Fig. 1. Fig. 3 is a partially enlarged plan view illustrating a region B shown in Fig. 1. Fig. 4 is a partially enlarged plan view illustrating a region C shown in Fig. 1. Fig. 5 is a partially enlarged longitudinal sectional view illustrating an element portion taken along the height direction. Fig. 6 is a partially enlarged longitudinal sectional view taken along the D-D line of Fig. 2 in the height direction.

A magnetic sensor S according to this embodiment includes a magneto-resistive effect element and is, for example, a geomagnetic sensor which is provided in a portable apparatus such as a mobile phone.

In the drawings, an X1-X2 direction and a Y1-Y2 direction are two directions which are orthogonal to each other in the horizontal plane and a Z direction is a direction orthogonal to the horizontal plane. The X1-X2 direction is referred to as a 'first horizontal direction' and the Y1-Y2 direction is referred to as a 'second horizontal direction'.

In the magnetic sensor S shown in Fig. 1, a magneto-resistive effect element forming region 13 is divided into four regions in the X1-X2 direction and the Y1-Y2 direction from the center 13a. A first magneto-resistive effect element 1, a second magneto-resistive effect element 2, a third magneto-resistive effect element 3, and a fourth magneto-resistive effect element 4 are formed in the divided regions. The magneto-resistive effect elements 1 to 4 include element portions, bias layers, and conductive layers which are connected in a meander shape, as described below. However, in Fig. 1, the shape of each of the magneto-resistive effect elements 2 to 4 is not shown.

As shown in Figs. 1 and 2, the first magneto-resistive effect element 1 and the third magneto-resistive effect element 3 are connected to an input terminal (Vdd) 5. In addition, the second magneto-resistive effect element 2 and the fourth magneto-resistive effect element 4 are connected to a ground terminal (GND) 6. A first output terminal (V1) 7 is connected between the first magneto-resistive effect element 1 and the second magneto-resistive effect element 2. A second output terminal (V2) 8 is connected between the third magneto-resistive effect element 3 and the fourth magneto-resistive effect element 4. As such, the first magneto-resistive effect element 1, the second magneto-resistive effect element 2, the third magneto-resistive effect element 3, and the fourth magneto-resistive effect element 4 form a bridge circuit.

As shown in Figs. 2 to 4, each of the magneto-resistive effect elements 1 to 4 includes a plurality of element portions 9, bias layers (permanent magnet layers) 10 which are connected to both sides of each element portion 9, and a plurality of soft magnetic bodies 12 which do not contact each element portion 9 and each bias layer 10.

Next, this embodiment will be described with an emphasis on the structure of the first magneto-resistive effect element 1.

Fig. 2 or Fig. 3 shows a portion of the first magneto-resistive effect element 1. In addition, Fig. 2, Fig. 3, Fig. 4, Fig. 7, and Fig. 8 all show the structure of the first magneto-resistive effect element 1 seen through an insulating layer 22 shown in Fig. 6.

As shown in Fig. 2, the bias layers 10 are arranged on both sides of each element portion 9 in the X1-X2 direction in the first magneto-resistive effect element 1. Each bias layer (permanent magnet layer) 10 is made of, for example, CoPt or CoPtCr.

As shown in Fig. 2, the element portion 9 includes a first element portion 9A and a second element portion 9B. The first element portion 9A and the second element portion 9B have the same laminated structure which will be described below with reference to Fig. 5, but the arrangements of the bias layers 10 connected to the element portions 9A and 9B are different from each other.

As shown in Fig. 2, a first bias layer 10A is connected to the X1 side of the first element portion 9A and a second bias layer 10B is connected to the X2 side thereof. The bias layers 10A and 10B each have a substantially triangular shape. The first bias layer 10A and the second bias layer 10B are reversed.

As shown in Fig. 2, the second bias layer 10B is connected to the X1 side of the second element portion 9B and the first bias layer 10A is connected to the X2 side thereof. As such, the arrangement of the bias layers 10A and 10B connected to the second element portion 9B is opposite to the arrangement of the bias layers 10A and 10B connected to the first element portion 9A.

When each bias layer 10 is magnetized, for example, in the Y2 direction, a first bias magnetic field B1 facing the X1 direction is applied to the first element portion 9A and a second bias magnetic field B2 facing the X2 direction is applied to the second element portion 9B.

As shown in Fig. 2, in each of the first bias layer 10A and the second bias layer 10B, an inclined plane 20 which is inclined with respect to both the X1-X2 direction and the Y1-Y2 direction is formed in the side surface which comes into contact with each element portion 9. In addition, a side surface opposite to the inclined plane 20 is an inclined plane 21. Since the side surface of each bias layer 10 which comes into contact with the element portion 9 is the inclined plane 20, it is possible to appropriately supply the bias magnetic fields B1 and B2 to each element portion 9 in a direction orthogonal to the magnetization direction (Y1-Y2) of each bias layer 10. The opposite inclined plane 21 is not necessarily provided. That is, the side surface opposite to the inclined plane 20 is not the inclined plane 21, but may extend in a straight line in the Y1-Y2 direction. However, when the opposite side surface is the inclined plane 21, the first bias layer 10A may have the same shape for both the first element portion 9A and the second element portion 9B and the second bias layer 10B may have a shape which is reverse to the shape of the first bias layer 10A. Therefore, it is possible to pattern the shape of the bias layer 10. As a result, a mask pattern used in a manufacturing process for forming the bias layer 10 is simplified, which is preferable. In addition, when the opposite side surface is the inclined plane 21, it is possible to reduce the size of each bias layer 10. In this case, each bias layer 10 is likely to be away from the magnetic path of the magnetic field passing through the soft magnetic body 12 and between the soft magnetic bodies 12, which will be described. Therefore, it is possible to further improve resistance to a strong magnetic field.

As shown in Fig. 2, the second bias layer 10B connected to the first element portion 9A is electrically connected to the first bias layer 10B connected to the second element portion 9B through a conductive layer 16 to form an element-connected body 17 which extends in the X1-X2 direction.

As shown in Fig. 2, a plurality of element-connected bodies 17 are arranged in the Y1-Y2 direction with a gap therebetween and the element-connected bodies 17 are electrically connected to each other by a conductive layer 18 to form the meander shape.

The conductive layers 16 and 18 are made of a non-magnetic conductive material such as Al, Cu, or Ti.

As shown in Fig. 6, each element portion 9 is formed on an insulating base layer 19 on the surface of a substrate 15. As shown in Fig. 6, an insulating layer 22 is formed on the element portion 9 and the bias layer 10 and each soft magnetic body 12 is formed on the planarized insulating layer 22. The bias layer 10 may be formed on the insulating base layer 19, similarly to the element portion 9. However, the arrangement of the bias layer 10 is not limited thereto.

The laminated structure of each element portion 9 will be described with reference to Fig. 5. Fig. 5 shows the cross-section of the element portion 9 taken in parallel to the Y1-Y2 direction.

As shown in Fig. 5, the element portion 9 is formed by laminating, for example, a non-magnetic base layer 60, a pinned magnetic layer 61, a non-magnetic layer 62, a free magnetic layer 63, and a protective layer 64 from the bottom in this order. Each layer of the element portion 9 is formed by, for example, a sputter.

In the embodiment shown in Fig. 5, the pinned magnetic layer 61 has a laminated ferri-structure of a first magnetic layer 61a, a second magnetic layer 61b, and a non-magnetic intermediate layer 61c which is interposed between the first magnetic layer 61a and the second magnetic layer 61b. The magnetic layers 61a and 61b are made of a soft magnetic material such as a CoFe alloy (cobalt-iron alloy) . The non-magnetic intermediate layer 61c is made of, for example, Ru. The non-magnetic layer 62 is made of a non-magnetic material such as Cu (copper) . The free magnetic layer 63 is made of a soft magnetic material such as a NiFe alloy (nickel-iron alloy). The protective layer 64 is made of, for example, Ta (tantalum).

In this embodiment, the pinned magnetic layer 61 has the laminated ferri-structure and the first magnetic layer 61a and the second magnetic layer 61b have a self-pinning structure in which they are magnetized and pinned in antiparallel. However, an antiferromagnetic layer may be formed so as to come into contact with the pinned magnetic layer, an exchange coupling field Hex may be generated between the antiferromagnetic layer and the pinned magnetic layer by an in-field heat treatment, and the magnetization of the pinned magnetic layer may be fixed in a predetermined direction. For example, in the self-pinning structure shown in Fig. 5, the antiferromagnetic layer is not used, and the magnetization of the magnetic layers 61a and 61c forming the pinned magnetic layer 61 is fixed, without performing the in-field heat treatment. The magnetization pinning force of each of the magnetic layers 61a and 61b may be so strong that magnetic fluctuation does not occur even when an external magnetic field is applied.

In this embodiment, the fixed magnetization direction (P1; the sensitivity axis direction) of the second magnetic layer 61b is the Y1 direction. The fixed magnetization direction (P1) is the fixed magnetization direction of the pinned magnetic layer 61.

As shown in Fig. 2, each element portion 9 has, for example, a rectangular shape elongated in the X1-X2 direction.

As shown in, for example, Fig. 2, a portion of the element portion 9 overlaps a portion of the bias layer 10. In this case, for example, portions of the free magnetic layer 63 and the protective layer 64 shown in Fig. 5 which overlap the bias layer 10 may be cut and the bias layer 10 may be formed in the cut concave portion. Alternatively, the entire laminated portion of the pinned magnetic layer 61 and the protective layer 64 in the element portion 9 which overlaps the bias layer 10 may be cut and the bias layer 10 may come into contact with the side surface of the element portion 9. When the entire portion of the element portion 9 which overlaps the bias layer 10 is cut, the outermost circumference of the element portion 9 does not have a rectangular shape and the side surface which comes into contact with the bias layer 10 is an inclined plane along the side surface 20 of the bias layer 10.

As shown in Figs. 2 and 6, each soft magnetic body 12 does not contact the element portion 9 and the bias layer 10. Each soft magnetic body 12 is made of, for example, NiFe, CoFe, CoFeSiB, or CoZrNb.

As shown in Fig. 2, each soft magnetic body 12 provided in the first magneto-resistive effect element 1 includes a Y1-side end portion 12a which faces the Y1 side of one of the adjacent element portions 9 in a plan view, a Y2-side end portion 12b which faces the Y2 side of the other element portion 9 in a plan view, and a connection portion 12c which connects the Y1-side end portion 12a and the Y2-side end portion 12b. The Y1-side end portion 12a, the Y2-side end portion 12b, and the connection portion 12c are integrally formed.

As shown in Fig. 2, the Y1-side end portion 12a and the Y2-side end portion 12b extend in parallel to the X1-X2 direction. The connection portion 12c is formed so as to be inclined with respect to both the X1-X2 direction and the Y1-Y2 direction.

As shown in Fig. 2, the soft magnetic bodies 12 formed in the first magneto-resistive effect element 1 have the same shape.

As shown in Fig. 2, the plurality of element portions 9, the plurality of bias layers 10, and the plurality of soft magnetic bodies 12 forming the first magneto-resistive effect element 1 have the same arrangement between the element-connected bodies 17.

Each of the element portions 9 forming the second magneto-resistive effect element 2, the third magneto-resistive effect element 3, and the fourth magneto-resistive effect element 4 shown in Figs. 2, 3, and 4 has the laminated structure shown in Fig. 5, similarly to the first magneto-resistive effect element 1, and the sensitivity axis direction is the Y1 direction. In addition, the bias layers 10 have the same shape and arrangement and the same magnetization direction (for example, the Y2 direction) in the first magneto-resistive effect element 1, the second magneto-resistive effect element 2, the third magneto-resistive effect element 3, and the fourth magneto-resistive effect element 4. For example, the first bias magnetic field B1 facing the X1 direction is applied to the first element portion 9A and the second bias magnetic field B2 facing the X2 direction is applied to the second element portion 9B.

The shape and arrangement of the soft magnetic body 12 forming the first magneto-resistive effect element 1 shown in Fig. 2 are the same as those in the fourth magneto-resistive effect element 4 shown in Figs. 3 and 4. Therefore, when the external magnetic field is applied, the change in electric resistance occurs in the first magneto-resistive effect element 1 and the fourth magneto-resistive effect element 4.

As shown in Figs. 2, 3, and 4, each soft magnetic body 12 forming the second magneto-resistive effect element 2 and the third magneto-resistive effect element 3 and each soft magnetic body 12 forming the first magneto-resistive effect element 1 and the fourth magneto-resistive effect element 4 are symmetric with respect to a line along the Y1-Y2 direction.

As such, the structure of each soft magnetic body 12 used in the second magneto-resistive effect element 2 and the third magneto-resistive effect element 3 is different from the structure of each soft magnetic body 12 used in the first magneto-resistive effect element 1 and the fourth magneto-resistive effect element 4.

When the soft magnetic body 12 used in each of the magneto-resistive effect elements 1 to 4 has the structure shown in Figs. 2 to 4, a change in the electric resistance of the first magneto-resistive effect element 1 and the fourth magneto-resistive effect element 4 can be different from a change in the electric resistance of the second magneto-resistive effect element 2 and the third magneto-resistive effect element 3. The change in the electric resistance of the first magneto-resistive effect element 1 and the fourth magneto-resistive effect element 4 is opposite to the change in the electric resistance of the second magneto-resistive effect element 2 and the third magneto-resistive effect element 3. That is, for example, when the electric resistance values of the first magneto-resistive effect element 1 and the fourth magneto-resistive effect element 4 tend to increase, the electric resistance values of the second magneto-resistive effect element 2 and the third magneto-resistive effect element 3 tend to decrease.

As shown in Figs. 2 and 3, a common soft magnetic body 12e can be provided between the first magneto-resistive effect element 1 and the third magneto-resistive effect element 3. In addition, as shown in Figs. 3 and 4, a common soft magnetic body 12f can be provided between the second magneto-resistive effect element 2 and the fourth magneto-resistive effect element 4.

Fig. 7 (a) is a partial plan view illustrating one element portion 9, the bias layers 10 connected to both sides of the element portion 9, and two soft magnetic bodies 12 facing the element portion 9 in the Y1-Y2 direction which form the first magneto-resistive effect element 1 and the fourth magneto-resistive effect element 4. Fig. 7(b) is a partial plan view illustrating one element portion 9, the bias layers 10 connected to both sides of the element portion 9, and two soft magnetic bodies 12 facing the element portion 9 in the Y1-Y2 direction which form the second magneto-resistive effect element 2 and the third magneto-resistive effect element 3.

It is assumed that an external magnetic field H1 is applied to each of the magneto-resistive effect elements 1 to 4 in the X1-X2 direction. As shown in Fig. 7(a), the external magnetic field H1 passes in the soft magnetic bodies 12 and between the magnetic bodies 12 forming the first magneto-resistive effect element 1 and the fourth magneto-resistive effect element 4 to form a magnetic path M1 which is represented by an arrow in Fig. 7(a). In addition, magnetic paths other than the magnetic path M1 are formed. However, the magnetic path M1 is shown as the main magnetic path.

As shown in Fig. 7(a), an external magnetic field H2 leaks between the end portions 12a and 12b of one soft magnetic body 12 and the other soft magnetic body 12. The external magnetic field H2 is applied to the element portion 9. The external magnetic field H2 applied to the element portion 9 is converted in the Y1 direction with respect to the external magnetic field H1 facing the X1-X2 direction or in a direction which leans toward the X1-X2 direction rather than the Y1 direction.

In this case, since the sensitivity axis direction of the element portion 9 is the Y1 direction, the magnetization direction of the free magnetic layer 63 is changed from the X1-X2 direction to the Y1 direction by the external magnetic field H2 and the electric resistance values of the first magneto-resistive effect element 1 and the fourth magneto-resistive effect element 4 decrease.

As shown in Fig. 7(b), the external magnetic field H1 passes through the soft magnetic bodies 12 forming the second magneto-resistive effect element 2 and the third magneto-resistive effect element 3 to form a magnetic path M2 which is represented by an arrow in Fig. 7(b). In addition, magnetic paths other than the magnetic path M2 are formed. However, the magnetic path M2 is shown as the main magnetic path.

As shown in Fig. 7(b), an external magnetic field H3 leaks between the end portions 12a and 12b of one soft magnetic body 12 and the other soft magnetic body 12 which face each other in the Y1-Y2 direction, with the element portion 9 interposed therebetween. The external magnetic field H3 is applied to the element portion 9.

As shown in Fig. 7(b), the external magnetic field H3 applied to the element portion 9 is converted in the Y2 direction with respect to the external magnetic field H1 facing the X1-X2 direction or in a direction which leans toward the X1-X2 direction rather than the Y2 direction. That is, the conversion directions of the external magnetic fields H2 and H3 are opposite to each other in Figs. 7(a) and 7(b).

Since the sensitivity axis direction of the element portion 9 is the Y1 direction, the magnetization direction of the free magnetic layer 63 is changed from the X1-X2 direction to the Y2 direction by the external magnetic field H3 and the electric resistance values of the second magneto-resistive effect element 2 and the third magneto-resistive effect element 3 increase.

As shown in Figs. 7(a) and 7(b), the directions of the external magnetic fields H2 and H3 applied to the element portion 9 are changed since the soft magnetic bodies 12 are arranged for the element portion 9 so as to be symmetric with respect to a line along the Y1-Y2 direction in Figs. 7(a) and 7(b).

In this embodiment, as shown in Fig. 2 or Fig. 7(a), a predetermined gap T1 is provided between each element portion 9 and the soft magnetic bodies 12 which are arranged on both sides of each element portion 9 in the Y1-Y2 direction in a plan view. The gap T1 is commonly provided in all of the magneto-resistive effect elements 1 to 4.

In this embodiment, the bias layer 10 does not overlap a virtual line E which connects edge portions 12d where the distance between the soft magnetic bodies 12 is the shortest in a plan view (which is shown in a portion of the third magneto-resistive effect element 3 shown in Fig. 2). The virtual line E passes through the element portion 9 arranged between the bias layers 10. This relationship is common to all of the magneto-resistive effect elements 1 to 4.

In this embodiment, the bias layer 10 is not provided between the soft magnetic bodies 12 of the element-connected bodies 17 which are adjacent to each other in the Y1-Y2 direction (see Figs. 2 to 4 and Figs. 7(a) and 7(b)).

The above-mentioned structure according to this embodiment makes it possible to improve resistance to a strong magnetic field, which will be described with reference to Fig. 7(a).

It is assumed that a very strong external magnetic field H1 is applied in the X2 direction. For example, the intensity of the external magnetic field H1 is in the range of several hundreds of Oe to several thousands of Oe.

As described above, the direction of the external magnetic field H1 is converted by the soft magnetic body 12 and is applied as the external magnetic field H2 to the element portion 9. However, in this embodiment, since the gap T1 is provided between the element portion 9 and the soft magnetic body 12 in a plan view, it is possible to weaken the external magnetic field H2 applied to the element portion 9 (it is possible to reduce magnetic field conversion efficiency).

In this embodiment, it is preferable that each gap T1 be about 22% to 40% of the gap T2 between the soft magnetic bodies 12 (the sum of two gaps T1 is about 44% to 80% of the gap T2). It is preferable that the element portion 9 be arranged at the center of the gap T2 between the soft magnetic bodies 12 and the gap T1 between the element portion 9 and one soft magnetic body 12 be substantially equal to the gap T1 between the element portion 9 and the other soft magnetic body 12.

In this embodiment, the plane area of the bias layer 10 is reduced such that the bias layer 10 has a small volume. In other words, when the size of the bias layer 10 is too large, the bias magnetic field applied to the element portion 9 is too strong even though the external magnetic field H2 applied to the element portion 9 is weak. As a result, the sensitivity of the element portion 9 is reduced.

Since the bias layer 10 with a small size is formed, it is possible to sufficiently reduce the overlap of the bias layer 10 with the soft magnetic body 12 in a plan view.

In this embodiment, the bias layer 10 with a small size is formed and the element portions 9 forming each element-connected body 17 are not connected through the bias layer 10, but are connected by the conductive layer 16 (for example, see Fig. 2).

In this embodiment, the bias layer 10 with a small size is formed and the bias layer 10 is not provided between the element-connected bodies 17. That is, the bias layer 10 is not provided in a region F shown in Fig. 7(a).

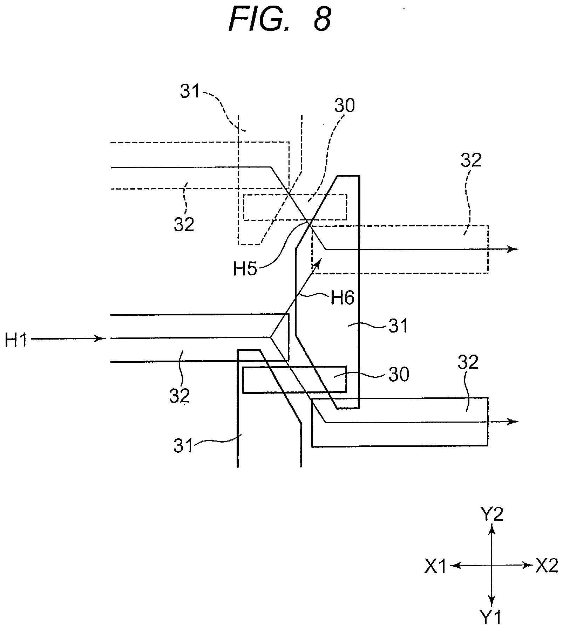

Fig. 8 shows the structure of a comparative example. In this comparative example, a plurality of element portions 30 are arranged in the Y1-Y2 direction with a gap therebetween and the element portions 30 are connected to each other by a bias layer 31 which extends in the Y1-Y2 direction. That is, unlike this embodiment, the element portions 30 are not connected to each other through the non-magnetic conductive layer 16.

The comparative example shown in Fig. 8 includes a soft magnetic body 32 which differs from the soft magnetic body 12 shown in Fig. 7(a) in shape and converts the external magnetic field H1 facing the X2 direction in the Y1 direction or a direction which leans toward the X1-X2 direction rather than the Y1 direction at the position of the element portion 30.

In the comparative example shown in Fig. 8, when the external magnetic field H1 is applied, for example, external magnetic fields H5 and H6 whose direction has been converted are applied to the bias layer 31. In this case, when the bias layer 31 is magnetized in the Y2 direction similarly to this embodiment, the external magnetic field H5 of the external magnetic fields H5 and H6 is particularly applied in a direction opposite to the magnetization direction of the bias layer 31. The magnetization of the bias layer 31 is likely to be broken since as the intensity of the external magnetic field H5 increases as the intensity of the external magnetic field H1 increases. That is, in the structure of the comparative example shown in Fig. 8, it is difficult to effectively improve resistance to a strong magnetic field.

In contrast, in this embodiment shown in Fig. 7(a), when the external magnetic field H1 is applied in the X2 direction, the magnetic path M1 is formed in the soft magnetic bodies 12 and in a space between the soft magnetic bodies 12 in the direction represented by the arrow. In this case, since the bias layer 10 deviates from the magnetic path M1, the intensity of the magnetic field applied to the bias layer 10 can be less than that in the comparative example shown in Fig. 8. In particular, it is possible to reduce the magnetic field applied to the bias layer 10 in a direction opposite to the magnetization direction. Although not shown in Fig. 7(a), the magnetic field is also generated between adjacent element-connected bodies 17, that is, the magnetic field is generated in the region F shown in Fig. 7 (a) . However, since the bias layer 10 is not provided in the region F, it is possible to minimize the influence of the magnetic field applied to the bias layer 10. Therefore, in this embodiment, it is possible to improve resistance to a strong magnetic field, as compared to the structure of the comparative example shown in Fig. 8.

The resistance to a strong magnetic field will be described with reference to Fig. 7(a) which shows the structure of the first magneto-resistive effect element 1 and the fourth magneto-resistive effect element 4. However, it is possible to obtain the same effect as described above, that is, it is possible to improve resistance to a strong magnetic field resistance in the second magneto-resistive effect element 2 and the third magneto-resistive effect element 3 shown in Fig. 7(b).

Next, resistance to a disturbance magnetic field which is orthogonal to the external magnetic field H1 will be described.

As shown in Fig. 7(c), it is assumed that a disturbance magnetic field H8 is applied in the Y2 direction. In this case, the disturbance magnetic field H8 forms a magnetic path M3 which passes through a connection portion 12c extending in the oblique direction of each soft magnetic body 12 and enters the soft magnetic bodies 12 adjacent to each other in the Y1-Y2 direction, as represented by an arrow.

As such, the soft magnetic body 12 has a shield effect against the disturbance magnetic field H8, can prevent the inflow of the disturbance magnetic field into the element portion 9 or the bias layer 10, and can reduce a change in the sensitivity of the sensor.

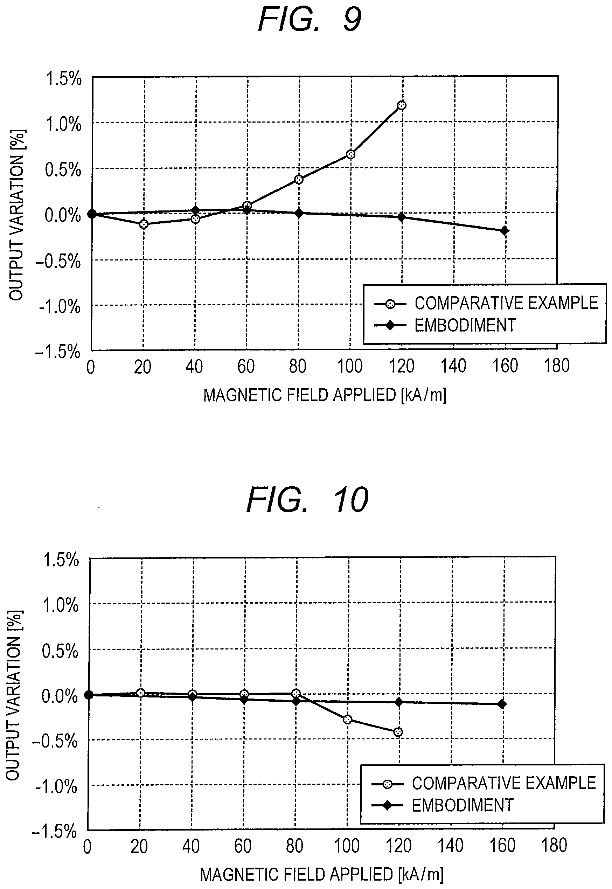

Fig. 9 shows the relationship between the intensity of the magnetic field when the magnetic field is applied in the X1-X2 direction and an output variation (midpoint voltage difference) after the magnetic field applied is removed, which is examined using the magnetic sensor S according to this embodiment and the magnetic sensor with the structure according to the comparative example shown in Fig. 8. The X1-X2 direction is the vertical direction as viewed from the sensitivity axis direction P1 of the element portion. The direction of the magnetic field is converted from the X1-X2 direction to the sensitivity axis direction at the position of the element portion by the soft magnetic body and the magnetic field flows into the element portion to change the electric resistance of the element portion. That is, both the magnetic sensors according to this embodiment and the comparative example are used to detect the external magnetic field in the X1-X2 direction and the external magnetic field in the X1-X2 direction is the magnetic field in the sensitivity axis direction. In addition, 1 Oe is about 79.6 A/m.

As can be seen from Fig. 9, in this embodiment, even when the intensity of the magnetic field applied is more than that in the comparative example, the output variation is less than that in the comparative example. That is, in this embodiment, even when the intensity of the magnetic field is more than that in the comparative example, the magnetization of the bias layer 10 is less likely to be broken than that in the comparative example and resistance to a strong magnetic field is more than that in the comparative example.

Fig. 10 shows the relationship between the intensity of the magnetic field when the disturbance magnetic field is applied to the Y1-Y2 direction and an output variation (midpoint voltage difference) after the magnetic field applied is removed, which is examined using the magnetic sensor S according to this embodiment and the magnetic sensor with the structure according to the comparative example shown in Fig. 8.

As can be seen from Fig. 10, in this embodiment, even when the intensity of the magnetic field applied is more than that in the comparative example, the output variation is less than that in the comparative example. That is, in this embodiment, even when the intensity of the magnetic field is more than that in the comparative example, the magnetization of the bias layer 10 is less likely to be broken than that in the comparative example and resistance to the disturbance magnetic field is more than that in the comparative example.

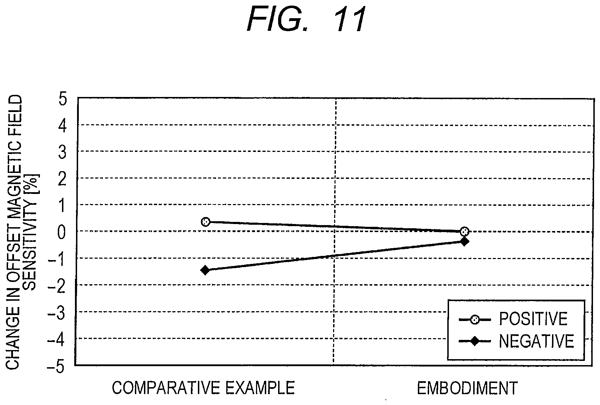

Fig. 11 shows a variation in the sensitivity when a disturbance magnetic field of 11 Oe is applied in the Y1-Y2 direction and a magnetic field of ±12 Oe is applied in the X1-X2 direction with respect to the sensitivity when no magnetic field is applied in the Y1-Y2 direction and a magnetic field of ±12 Oe is applied in the X1-X2 direction, which is examined using the magnetic sensor S according to this embodiment and the magnetic sensor with the structure according to the comparative example shown in Fig. 8. In Fig. 11, for example, the term 'Positive' means that the disturbance magnetic field is applied in the Y2 direction and the term 'Negative' means that the disturbance magnetic field is generated in the Y1 direction.

A 'change in offset magnetic field sensitivity' represented by the vertical axis in Fig. 11 is calculated as follows:

```
a change in offset magnetic field sensitivity =

[(sensitivity (when a magnetic field of 11 Oe is applied in the

Y1-Y2 direction)/sensitivity (when no magnetic field is applied in the Y1-Y2 direction))-1]×100(%).
```

As the absolute value of the change in offset magnetic field sensitivity is closer to zero, sensitivity deviation is reduced even in a state in which the disturbance magnetic field is applied in the Y1-Y2 direction. Therefore, it is possible to obtain high detection accuracy.

As can be seen from Fig. 11, the change in offset magnetic field sensitivity (absolute value) in this embodiment is less than that in the comparative example. This embodiment has high resistance to the disturbance magnetic field and can minimize the disturbance magnetic field which leaks to the element portion 9 or the bias layer 10 using a so-called shield effect of the soft magnetic body 12. However, in the comparative example shown in Fig. 8, since the shield effect of the soft magnetic body 12 is less than that in this embodiment, the disturbance magnetic field affects the element portion or the bias layer, which results in a large change in offset magnetic field sensitivity (absolute value).

In this embodiment, as shown in Fig. 2, the fixed magnetization directions (P1; the sensitivity axis direction) of the pinned magnetic layers 61 in the first element portion 9A and the second element portion 9B are the same. However, the directions of the bias magnetic fields B1 and B2 are opposite to each other and the magnetization direction of the free magnetic layer 63 in the first element portion 9A is opposite to the magnetization direction of the free magnetic layer 63 in the second element portion 9B. Therefore, when the sensitivity of each element portion 9 is changed by the external magnetic field, the shift direction of the sensitivity of the first element portion 9A is opposite to the shift direction of the sensitivity of the second element portion 9B and it is possible to reduce a variation in the sensitivity of the entire magneto-resistive effect element including the first element portion 9A and the second element portion 9B. Therefore, in this embodiment, it is possible to improve the linearity of output characteristics.

In this embodiment, as shown in Figs. 2, 3, and 4, the portions 9 and the bias layers 10 in all of the magneto-resistive effect elements 1 to 4 can be formed at a time. This is because the element portions can have the same sensitivity axis direction P1 and the bias layers 10 can have the same magnetization direction in all of the magneto-resistive effect elements 1 to 4. Therefore, in this embodiment, the first magneto-resistive effect element 1, the second magneto-resistive effect element 2, the third magneto-resistive effect element 3, and the fourth magneto-resistive effect element 4 can be formed by one film forming process.

In this embodiment, as shown in Figs. 7 (a) and 7 (b), when the external magnetic field H1 enters the soft magnetic body 12, the magnetic paths M1 and M2 which pass through the soft magnetic body 12 and the space between the soft magnetic bodies 12 in zigzag can be formed and it is possible to uniformly supply the conversion magnetic field to the entire element while converting the direction of the magnetic field at the position of the element portion 9.

The structure of the magnetic sensor S shown in Fig. 1 is used to detect the external magnetic field in the X1-X2 direction. When the magnetic sensor S is rotated 90 degrees in the horizontal direction, a sensor for detecting the external magnetic field in the Y1-Y2 direction can be formed. Therefore, since this embodiment includes the sensor structure shown in Fig. 1 and the sensor structure which is rotated 90 degrees, it is possible to achieve the magnetic sensor S capable of detecting the magnetic field in the X and Y directions.

The shape of the soft magnetic body 12 is not limited to, for example, that shown in Fig. 2. For example, the connection portion 12c of the soft magnetic body 12 is inclined, but may extend in parallel to the Y1-Y2 direction. However, when the connection portion 12c is formed so as to be inclined, it is easy to appropriately generate the conversion magnetic field between the soft magnetic bodies 12 through the element portion 9 and the element portion 9 or the bias layer 10 is less likely to be adversely affected. As shown in Fig. 7(c), since the connection portion 12c of one of the soft magnetic bodies 12 provided in adjacent element-connected bodies 17 is disposed on the extension line of the connection portion 12c of the other soft magnetic body 12, it is possible to improve the shield effect against the disturbance magnetic field H8.

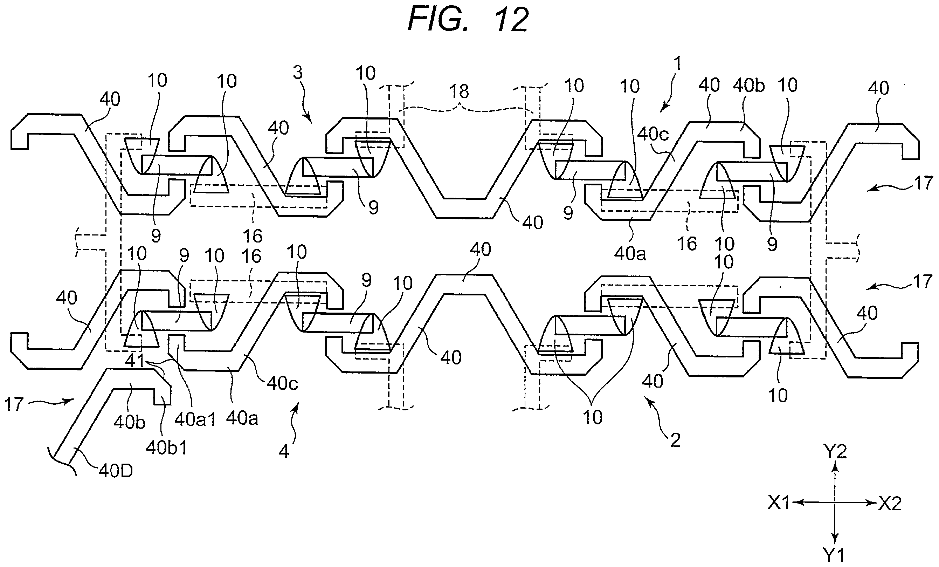

Alternatively, a soft magnetic body 40 may be configured as shown in Fig. 12. Fig. 12 shows the same region as that shown in Fig. 3 in the magnetic sensor. Magneto-resistive effect elements 1 to 4 shown in Fig. 12 are similar to the magneto-resistive effect elements 1 to 4 shown in Fig. 3 except for the shape of the soft magnetic body.

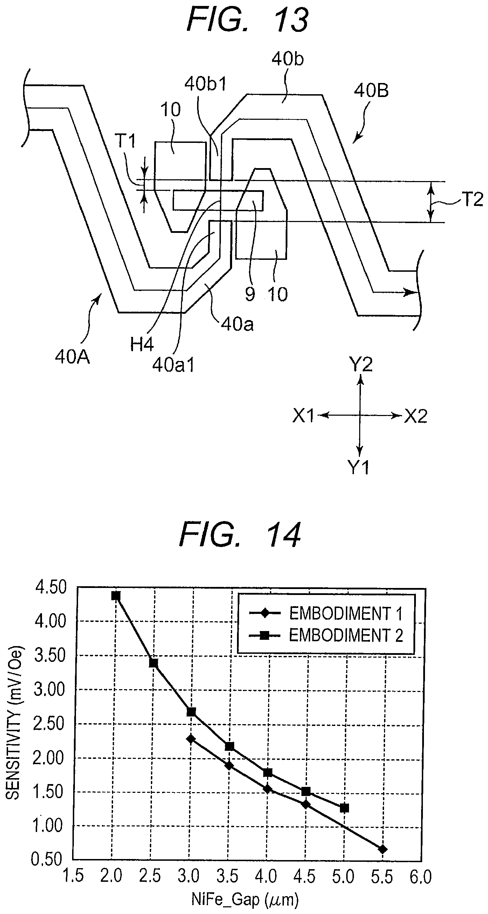

As shown in Figs. 12 and 13, the soft magnetic body 40 includes a Y1-side end portion 40a which is disposed on the Y1 side of the element portion 9, a Y2-side end portion 40b which is disposed on the Y2 side of the element portion 9, and a connection portion 40c which connects the Y1-side end portion 40a and the Y2-side end portion 40b.

As shown in Fig. 13, the leading ends 40a1 and 40b1 of the Y1-side end portion 40a and the Y2-side end portion 40b of the soft magnetic bodies 40A and 40B which are arranged on both sides of the element portion 9 in the Y1-Y2 direction are each bent toward the element portion 9 in a plan view.

As shown in Fig. 13, the leading end 40a1 of one soft magnetic body 40A and the leading end 40b1 of the other soft magnetic body 40B face each other in the Y1-Y2 direction with the gap T2 therebetween.

As shown in Fig. 13, a gap T1 is provided between the element portion 9 and each of the leading ends 40a1 and 40b1 of the soft magnetic bodies 40A and 40B in a plan view.

As shown in Fig. 13, since the gap T1 is provided between the element portion 9 and each of the soft magnetic bodies 40A and 40B, it is possible to weaken the external magnetic field H4 applied to the element portion 9. In addition, it is possible to concentrate the inflow of magnetic flux from the soft magnetic body 40 to the element portion 9 (effectively facilitate the inflow of magnetic flux) and thus improve an output.

According to the structure shown in Fig. 7, the external magnetic field other than the external magnetic fields H2 and H3 which pass through the element portion 9 is likely to leak. For example, the external magnetic field is likely to leak between the soft magnetic bodies 17 of adjacent element-connected bodies 17 as shown in Fig. 7(a) and the output is likely to be reduced.

In contrast, when the leading ends 40a1 and 40b1 of the soft magnetic bodies 40 are bent toward the element portion 9 as shown in Figs. 12 and 13, the magnetic field leaking between, for example, the soft magnetic bodies 40 of the adjacent element-connected bodies 17 is reduced. Therefore, it is possible to increase the efficiency of the inflow of magnetic flux to the element portion 9 and thus improve the output.

Fig. 14 shows the relationship between the gap T2 (see Fig. 7(a) and Fig. 13) between the soft magnetic bodies and sensitivity (mV/Oe), using the magnetic sensor (Embodiment 1) with the structure shown in Figs. 2 to 4 and Fig. 7 and the magnetic sensor (Embodiment 2) with the structure shown in Figs. 12 and 13. In Fig. 14, the term 'sensitivity' means a value obtained by dividing an output value by the intensity of the supplied external magnetic field H1.

As shown in Fig. 14, in Embodiment 1 and Embodiment 2, as the gap T2 between the soft magnetic bodies increases, the sensitivity is reduced. The sensitivity in Embodiment 2 is higher than that in Embodiment 1.

As shown in Fig. 12, in order to improve the shield effect against the disturbance magnetic field between one soft magnetic body 40C and the other soft magnetic body 40D of the adjacent element-connected bodies 17, the leading end 40a1 of the Y1-side end portion 40a of the soft magnetic body 40C is close to the leading end 40b1 of the Y2-side end portion 40b of the other soft magnetic body 40D. In addition, planes 41 which are inclined with respect to the X1-X2 direction and the Y1-Y2 direction are provided in opposite portions of the leading end 40a1 of the Y1-side end portion 40a of the soft magnetic body 40C and the leading end 40b1 of the Y2-side end portion 40b of the other soft magnetic body 40D which face each other. Therefore, it is easy for the disturbance magnetic field to pass between the soft magnetic bodies 40C and 40D.

EXPLANATION OF REFERENCES

| B1, B2: | BIAS MAGNETIC FIELD |
| H1, H2, H3, H5, H6: | EXTERNAL MAGNETIC FIELD |
| H8: | DISTURBANCE MAGNETIC FIELD |
| M1, M2, M3: | MAGNETIC PATH |
| S: | MAGNETIC SENSOR |
| 1 to 4: | MAGNETO-RESISTIVE EFFECT ELEMENT |
| 9, 9A, 9B: | ELEMENT PORTION |
| 10, 10A, 10B: | BIAS LAYER |
| 12, 40: | SOFT MAGNETIC BODY |
| 12c, 40c: | CONNECTION PORTION |
| 40a1, 40b1: | LEADING END |
| 17: | ELEMENT-CONNECTED BODY |
| 20: | INCLINED PLANE |
| 61: | PINNED MAGNETIC LAYER |
| 63: | FREE MAGNETIC LAYER |

## Claims

1. A magnetic sensor (S) comprising:

   a plurality of element portions (9) each of which is formed by laminating a magnetic layer and a non-magnetic layer and has a magneto-resistive effect;
   bias layers (10) that are provided on both sides of each element portion (9) in a first horizontal direction (X1-X2); and
   soft magnetic bodies (12) that are provided on both sides of each element portion (9) in a second horizontal direction (Y1-Y2) orthogonal to the first horizontal direction (X1-X2) so as not to contact each element portion (9) and each bias layer (10),
   wherein a sensitivity axis direction of each element portion (9) is the second horizontal direction (Y1-Y2),
   a magnetization direction of each bias layer (10) is the second horizontal direction (Y1-Y2),
   each bias layer (10) is configured such that a bias magnetic field is supplied in the first horizontal direction (X1-X2) from each bias layer (10) to each element portion (9),
   the plurality of element portions (9) are arranged in the first horizontal direction (X1-X2) with a gap therebetween and the bias layers (10) connected to the element portions (9) which are adjacent to each other in the first horizontal direction (X1-X2) are connected to each other by a conductive layer (16), thereby forming an element-connected body (17),
   a plurality of the element-connected bodies (17) are arranged in the second horizontal direction (Y1-Y2) with a gap therebetween and end portions of the element-connected bodies (17) are connected to each other in a meander shape by a conductive layer (18),
   the bias layer (10) does not overlap a virtual line (E) which connects edge portions (12d) where the distance between the soft magnetic bodies (12) is the shortest in a straight line in a plan view and the virtual line (E) passes through the element portion (9) disposed between the bias layers (10), and
   the bias layer (10) is not provided between the soft magnetic bodies (12) of the element-connected bodies (17) which are adjacent to each other in the second horizontal direction (Y1-Y2),
   **characterized in that**

each soft magnetic body (12) is configured such that, when an external magnetic field (H1) is applied in the first horizontal direction (X1-X2), the soft magnetic bodies (12) which are provided on both sides of each element portion (9) in the second horizontal direction (Y1-Y2) convert the external magnetic field in a horizontal direction different from the first horizontal direction (X1-X2) and supply the external magnetic field to the element portion (9), and

a predetermined gap (T1) is provided between each element portion (9) and each of the soft magnetic bodies (12) which are provided on both sides of each element portion (9) in the second horizontal direction (Y1-Y2) in a plan view.

2. The magnetic sensor (S) according to claim 1,
wherein the soft magnetic body (12) includes a Y1-side end portion (12a) which is provided on a Y1 side of one of the element portions (9), which are adjacent to each other in each element-connected body (17), in the second horizontal direction (Y1-Y2), a Y2-side end portion (12b) which is provided on a Y2 side of the other element portion (9) opposite to the Y1 side, and a connection portion (12c) which connects the Y1-side end portion (12a) and the Y2-side end portion (12b).

3. The magnetic sensor (S) according to claim 2,
wherein the connection portion (12c) is provided so as to be inclined with respect to both the first horizontal direction (X1-X2) and the second horizontal direction (Y1-Y2).

4. The magnetic sensor (S) according to claim 2 or 3,
wherein each soft magnetic body (12) is configured such that a magnetic path for a disturbance magnetic field applied in the second horizontal direction (Y1-Y2) can be formed between the soft magnetic bodies (12) provided in the adjacent element-connected bodies (17).

5. The magnetic sensor (S) according to claim 4,
wherein the connection portion (12c) of one of the soft magnetic bodies (12) provided in the adjacent element-connected bodies (17) is disposed on an extension line of the connection portion (12c) of the other soft magnetic body.

6. The magnetic sensor (S) according to any one of claims 2 to 4,
wherein a leading end of the Y1-side end portion (12a) of one of the soft magnetic bodies (12) which are provided on both sides of each element portion (9) in the second horizontal direction (Y1-Y2) and a leading end of the Y2-side end portion (12b) of the other soft magnetic body (12) are bent toward the element portion (9) in a plan view, and the leading end of the one soft magnetic body (12) and the leading end of the other soft magnetic body (12) face each other in the second horizontal direction (Y1-Y2) with a gap (T2) therebetween.

7. The magnetic sensor (S) according to any one of claims 1 to 6,
wherein the arrangement of the element portion (9), the bias layer (10), and the soft magnetic body (12) is the same in each element-connected body (17).

8. The magnetic sensor (S) according to any one of claims 1 to 7,
wherein each element-connected body (17) includes a first element portion and a second element portion which are adjacent to each other in the first horizontal direction (X1-X2), and the structure of the bias layers (10) which are provided on both sides of the first element portion in the first horizontal direction (X1-X2) is different from the structure of the bias layers (10) which are provided on both sides of the second element portion in the first horizontal direction (X1-X2) such that the direction of a first bias magnetic field applied to the first element portion is opposite to the direction of a second bias magnetic field applied to the second element portion.

9. The magnetic sensor (S) according to any one of claims 1 to 8,
wherein a magneto-resistive effect element forming region is divided into four regions in the first horizontal direction (X1-X2) and the second horizontal direction (Y1-Y2),
a first magneto-resistive effect element (1), a second magneto-resistive effect element (2), a third magneto-resistive effect element (3), and a fourth magneto-resistive effect element (4) each of which includes the element portion (9), the bias layer (10), and the soft magnetic body (12) and which form a bridge circuit are formed in the four regions, respectively,
a change in electric resistance with respect to the external magnetic field applied in the first horizontal direction (X1-X2) is the same in the first magneto-resistive effect element (1) and the fourth magneto-resistive effect element (4), the change in electric resistance with respect to the external magnetic field applied in the first horizontal direction (X1-X2) is the same in the second magneto-resistive effect element (2) and the third magneto-resistive effect (3) element, and is different in the first magneto-resistive effect element (1) and the fourth magneto-resistive effect element (4),

the structure of each element portion (9) and each bias layer (10) is the same in the magneto-resistive effect elements (1, 2, 3, 4),

the soft magnetic bodies (12) in the first magneto-resistive effect element (1) and the fourth magneto-resistive effect element (4) have the same structure,

the soft magnetic bodies (12) in the second magneto-resistive effect element (2) and the third magneto-resistive effect element (3) have the same structure, and

the soft magnetic bodies (12) in the first magneto-resistive effect element (1) and the fourth magneto-resistive effect element (4) are different from each other such that the conversion direction of the magnetic field applied to each element portion in the first magneto-resistive effect element (1) is opposite to that of the magnetic field applied to each element portion in the fourth magneto-resistive effect element (4).

10. The magnetic sensor (S) according to claim 9,
wherein the soft magnetic bodies (12) forming the first magneto-resistive effect element (1) and the fourth magneto-resistive effect element (4) and the soft magnetic bodies (12) forming the second magneto-resistive effect element (2) and the third magneto-resistive effect element (3) are symmetric with respect to a line along the second horizontal direction (Y1-Y2).

11. A magnetic sensor (S) according to any of the previous claims, comprising:
each soft magnetic body (12) is configured such that a magnetic path for a disturbance magnetic field applied in the second horizontal direction (Y1-Y2) can be formed between the soft magnetic bodies provided in the adjacent element-connected bodies (17).

**Patentansprüche**

1. Magnetsensor (S), aufweisend:

eine Mehrzahl von Elementbereichen (9), von denen jeder durch Laminieren einer Magnetschicht und einer nichtmagnetischen Schicht gebildet ist und einen Magnetowiderstandseffekt aufweist;
Vorspannungsschichten (10), die auf beiden Seiten von jedem Elementbereich (9) in einer ersten horizontalen Richtung (X1-X2) vorgesehen sind; und

weichmagnetische Körper (12), die auf beiden Seiten von jedem Elementbereich (9) in einer zweiten horizontalen Richtung (Y1-Y2) orthogonal zu der ersten horizontalen Richtung (X1-X2) derart vorgesehen sind, dass sie nicht mit einem jeweiligen Elementbereich (9) und einer jeweiligen Vorspannungsschicht (10) in Kontakt treten, wobei es sich bei einer Empfindlichkeitsachsenrichtung jedes Elementbereichs (9) um die zweite horizontale Richtung (Y1-Y2) handelt,

wobei es sich bei einer Magnetisierungsrichtung jeder Vorspannungsschicht (10) um die zweite horizontale Richtung (Y1-Y2) handelt,
wobei jede Vorspannungsschicht (10) derart ausgebildet ist, dass ein Vorspannungsmagnetfeld in der ersten horizontalen Richtung (X1-X2) von einer jeweiligen Vorspannungsschicht (10) einem jeweiligen Elementbereich (9) zugeführt wird,

wobei die Mehrzahl von Elementbereichen (9) in der ersten horizontalen Richtung (X1-X2) mit einem Spalt dazwischen angeordnet sind und die Vorspannungsschichten (10), die mit den in der ersten horizontalen Richtung (X1-X2) einander benachbarten Elementbereichen (9) verbunden sind, durch eine leitfähige Schicht (16) miteinander verbunden sind und dadurch ein zu einem Element verbundener Körper (17) gebildet wird,

wobei eine Mehrzahl der zu einem Element verbundenen Körper (17) in der zweiten horizontalen Richtung (Y1-Y2) mit einem Spalt dazwischen angeordnet sind und Endbereiche der zu einem Element verbundenen Körper (17) durch eine leitfähige Schicht (18) mäanderförmig miteinander verbunden sind,

wobei die Vorspannungsschicht (10) eine virtuelle Linie (E), die Randbereiche (12d) verbindet, wo der Abstand zwischen den weichmagnetischen Körpern (12) in einer Draufsicht in einer geraden Linie am kürzesten ist, nicht überlappt und die virtuelle Linie (E) durch den zwischen den Vorspannungsschichten (10) angeordneten Elementbereich (9) verläuft, und

wobei die Vorspannungsschicht (10) nicht zwischen den weichmagnetischen Körpern (12) der zu einem Element verbundenen Körper (17) vorgesehen sind, die in der zweiten horizontalen Richtung (Y1-Y2) einander benachbart sind,

**dadurch gekennzeichnet,**

**dass** jeder weichmagnetische Körper (12) derart ausgebildet ist, dass bei Anlegen eines externen Magnetfelds (H1) in der ersten horizontalen Richtung (X1-X2) die weichmagnetischen Körper (12), die auf beiden Seiten von einem jeweiligen Elementbereich (9) in der zweiten horizontalen Richtung (Y1-Y2) vorgesehen sind, das externe Magnetfeld in eine von der ersten horizontalen Richtung (X1-X2) verschiedene horizontale Richtung umwandeln und das externe Magnetfeld dem Elementbereich (9) zuführen, und

**dass** ein vorbestimmter Spalt (T1) zwischen jedem Elementbereich (9) und jedem der weichmagnetischen Körper (12) vorgesehen ist, die in einer Draufsicht auf beiden Seiten von jedem Elementbereich (9) in der zweiten horizontalen Richtung (Y1-Y2) vorgesehen sind.

2. Magnetsensor (S) nach Anspruch 1,
wobei der weichmagnetische Körper (12) einen Y1-seitigen Endbereich (12a), der auf einer Y1-Seite von einem der Elementbereiche (9) vorgesehen ist, die in jedem zu einem Element verbundenen Körper (17) in der zweiten horizontalen Richtung (Y1-Y2) einander benachbart sind, einen Y2-seitigen Endbereich (12b), der auf einer Y2-Seite von dem der Y1-Seite gegenüberliegenden, anderen Elementbereich (9) vorgesehen ist, sowie einen Verbindungsbereich (12c) aufweist, der den Y1-seitigen Endbereich (12a) und den Y2-seitigen Endbereich (12b) verbindet.

3. Magnetsensor (S) nach Anspruch 2,
wobei der Verbindungsbereich (12c) derart vorgesehen ist, dass er sowohl in Bezug auf die erste horizontale Richtung (X1-X2) als auch in Bezug auf die zweite horizontale Richtung (Y1-Y2) geneigt ist.

4. Magnetsensor (S) nach Anspruch 2 oder 3,
wobei jeder weichmagnetische Körper (12) derart ausgebildet ist, dass ein Magnetpfad für ein in der zweiten horizontalen Richtung (Y1-Y2) angelegtes Störmagnetfeld zwischen den weichmagnetischen Körpern (12) gebildet werden kann, die in den einander benachbarten, zu einem Element verbundenen Körpern (17) vorgesehen sind.

5. Magnetsensor (S) nach Anspruch 4,
wobei der Verbindungsbereich (12c) von einem der weichmagnetischen Körper (12), die in den einander benachbarten, zu einem Element verbundenen Körpern (17) vorgesehen sind, auf einer Verlängerungslinie des Verbindungsbereichs (12c) des anderen weichmagnetischen Körpers angeordnet ist.

6. Magnetsensor (S) nach einem der Ansprüche 2 bis 4,
wobei ein vorderes Ende des Y1-seitigen Endbereichs (12a) von einem der weichmagnetischen Körper (12), die auf beiden Seiten von jedem Elementbereich (9) in der zweiten horizontalen Richtung (Y1-Y2) vorgesehen sind, und ein vorderes Ende des Y2-seitigen Endbereichs (12b) von dem anderen weichmagnetischen Körper (9) in einer Draufsicht in Richtung auf den Elementbereich (9) gebogen sind, und
wobei das vordere Ende des einen weichmagnetischen Körpers (12) und das vordere Ende des anderen weichmagnetischen Körpers (12) einander in der zweiten horizontalen Richtung (Y1-Y2) mit einem Spalt (T2) dazwischen zugewandt sind.

7. Magnetsensor (S) nach einem der Ansprüche 1 bis 6,
wobei die Anordnung des Elementbereichs (9), der Vorspannungsschicht (10) und des weichmagnetischen Körpers (12) in jedem zu einem Element verbundenen Körper (17) gleich ist.

8. Magnetsensor (S) nach einem der Ansprüche 1 bis 7,
wobei jeder zu einem Element verbundene Körper (17) einen ersten Elementbereich und einen zweiten Elementbereich aufweist, die einander in der ersten horizontalen Richtung (X1-X2) benachbart sind, und die Struktur der Vorspannungsschichten (10), die auf beiden Seiten von dem ersten Elementbereich in der ersten horizontalen Richtung (X1-X2) vorgesehen sind, sich von der Struktur der Vorspannungsschichten (10) unterscheidet, die auf beiden Seiten von dem zweiten Elementbereich (10) in der ersten horizontalen Richtung (X1-X2) vorgesehen sind, so dass die Richtung eines an den ersten Elementbereich angelegten ersten Vorspannungsmagnetfelds entgegengesetzt zu der Richtung eines an den zweiten Elementbereich angelegten zweiten Vorspannungsmagnetfelds ist.

9. Magnetsensor (S) nach einem der Ansprüche 1 bis 8,
wobei eine Region, die Elemente mit Magnetowiderstandseffekt bildet, in der ersten horizontalen Richtung (X1-X2) und der zweiten horizontalen Richtung (Y1-Y2) in vier Regionen unterteilt ist,
wobei ein erstes Magnetowiderstandseffekt-Element (1), ein zweites Magnetowiderstandseffekt-Element (2), ein drittes Magnetwiderstandseffekt-Element (3) bzw. ein viertes Magnetowiderstandseffekt-Element (4), die jeweils den Elementbereich (9), die Vorspannungsschicht (10) und den weichmagnetischen Körper (12) beinhalten und eine Brückenschaltung bilden, in den vier Regionen gebildet sind,

wobei eine Änderung des elektrischen Widerstands in Bezug auf das in der ersten horizontalen Richtung (X1-X2) angelegte externe Magnetfeld bei dem ersten Magnetowiderstandseffekt-Element (1) und dem vierten Magnetowiderstandseffekt-Element (4) gleich ist,

wobei die Änderung des elektrischen Widerstands in Bezug auf das in der ersten horizontalen Richtung (X1-X2) angelegte externe Magnetfeld bei dem zweiten Magnetowiderstandseffekt-Element (2) und dem dritten Magnetowiderstandseffekt-Element (3) gleich ist und bei dem ersten Magnetowiderstandseffekt-Element (1) und dem vierten Magnetowiderstandseffekt-Element (4) anders ist,

wobei die Struktur jedes Elementbereichs (9) und jeder Vorspannungsschicht (10) in den Magnetowiderstandseffekt-Elementen (1, 2, 3, 4) gleich ist,

wobei die weichmagnetischen Körper (12) in dem ersten Magnetowiderstandseffekt-Element (1) und dem vierten Magnetowiderstandseffekt-Element (4) die gleiche Struktur aufweisen,

wobei die weichmagnetischen Körper (12) in dem zweiten Magnetowiderstandseffekt-Element (2) und dem dritten Magnetowiderstandseffekt-Element (3) die gleiche Struktur aufweisen, und

wobei die weichmagnetischen Körper (12) in dem ersten Magnetowiderstandseffekt-Element (1) und dem vierten Magnetowiderstandseffekt-Element (4) sich derart voneinander unterscheiden, dass die Umwandlungsrichtung des an jeden Elementbereich in dem ersten Magnetowiderstandseffekt-Element (1) angelegten Magnetfelds entgegengesetzt zu der des an jeden Elementbereich in dem vierten Magnetowiderstandseffekt-Element (4) angelegten Magnetfelds ist.

10. Magnetsensor (S) nach Anspruch 9,

wobei die weichmagnetischen Körper (12), die das erste Magnetowiderstandseffekt-Element (1) und das vierte Magnetowiderstandseffekt-Element (4) bilden, und die weichmagnetischen Körper (12), die das zweite Magnetowiderstandseffekt-Element (2) und das dritte Magnetowiderstandseffekt-Element (3) bilden, in Bezug auf eine Linie entlang der zweiten horizontalen Richtung (Y1-Y2) symmetrisch sind.

11. Magnetsensor (S) nach einem der vorhergehenden Ansprüche, aufweisend:

jeder weichmagnetische Körper (12) ist derart ausgebildet, dass ein Magnetpfad für ein in der zweiten horizontalen Richtung (Y1-Y2) angelegtes Störmagnetfeld zwischen den weichmagnetischen Körpern gebildet werden kann, die in den einander benachbarten, zu einem Element verbundenen Körpern (17) vorgesehen sind.


**Revendications**

1. Capteur magnétique (S) comprenant :

   une pluralité de parties d'élément (9), chacune d'entre elles étant formée par la stratification d'une couche magnétique et d'une couche non magnétique et ayant un effet magnétorésistif ;

   des couches de polarisation (10) situées sur les deux côtés de chaque partie d'élément (9) dans un premier sens horizontal (X1-X2) ; et

   des corps magnétiques doux (12) situés sur les deux côtés de chaque partie d'élément (9) dans un deuxième sens horizontal (Y1-Y2) perpendiculaire au premier sens horizontal (X1-X2) de manière à ne pas être en contact avec chaque partie d'élément (9) ni chaque couche de polarisation (10),

   dans lequel un sens de l'axe de sensibilité de chaque partie d'élément (9) est le deuxième sens horizontal (Y1-Y2),

   un sens de magnétisation de chaque couche de polarisation (10) est le deuxième sens horizontal (Y1-Y2),

   chaque couche de polarisation (10) est configurée de telle sorte qu'un champ magnétique de polarisation est fourni dans le premier sens horizontal (X1-X2) de chaque couche de polarisation (10) vers chaque partie d'élément (9),

   la pluralité de parties d'élément (9) sont agencées dans le premier sens horizontal (X1-X2) avec un écart les unes entre les autres et les couches de polarisation (10) reliées aux parties d'élément (9) qui leur sont adjacentes dans le premier sens horizontal (X1-X2) sont reliées les unes aux autres par une couche conductrice (16), formant ainsi un corps élémentaire relié (17),

   une pluralité des corps élémentaires reliés (17) sont agencés dans le deuxième sens horizontal (Y1-Y2) avec un écart les uns entre les autres et les parties d'extrémité des corps élémentaires reliés (17) sont reliées les unes aux autres en forme de méandre par une couche conductrice (18),

   la couche de polarisation (10) ne chevauche pas une ligne virtuelle (E) qui relie des parties de bord (12d) où la distance entre les corps magnétiques doux (12) est la plus courte selon une ligne directe dans une vue en plan, et la ligne virtuelle (E) traverse la partie d'élément (9) située entre les couches de polarisation (10), et la couche de polarisation (10) n'est pas présente entre les corps magnétiques doux (12) des corps élémentaires reliés (17) qui sont adjacents les uns par rapport aux autres dans le deuxième sens horizontal (Y1-Y2),
**caractérisé en ce que**,
chaque corps magnétique doux (12) est configuré de sorte que, lorsqu'un champ magnétique externe (H1) est appliqué dans le premier sens horizontal (X1-X2), les corps magnétiques doux (12) qui sont situés sur les deux côtés de chaque partie d'élément (9) dans le deuxième sens horizontal (Y1-Y2) convertissent le champ magnétique externe dans un sens horizontal différent du premier sens horizontal (X1-X2) et envoient le champ magnétique externe à la partie d'élément (9), et
un écart prédéterminé (T1) est ménagé entre chaque partie d'élément (9) et chacun des corps magnétiques doux (12) qui sont situés des deux côtés de chaque partie d'élément (9) dans le deuxième sens horizontal (Y1-Y2) dans une vue en plan.

2. Le capteur magnétique (S) selon la revendication 1,
dans lequel le corps magnétique doux (12) comprend une partie d'extrémité côté Y1 (12a) qui est située sur un côté Y1 de l'une des parties d'élément (9), qui sont adjacentes dans chaque corps élémentaire relié (17), dans le deuxième sens horizontal (Y1-Y2), une partie d'extrémité côté Y2 (12b) qui est située sur un côté Y2 de l'autre partie d'élément (9) opposé au côté Y1, et une partie raccordement (12c) qui relie la partie d'extrémité côté Y1 (12a) et la partie d'extrémité côté Y2 (12b).

3. Le capteur magnétique (S) selon la revendication 2,
dans lequel la partie raccordement (12c) est constituée de manière à être inclinée par rapport à la fois au premier sens horizontal (X1-X2) et au deuxième sens horizontal (Y1-Y2).

4. Le capteur magnétique (S) selon la revendication 2 ou 3,
dans lequel chaque corps magnétique doux (12) est configuré de telle sorte qu'un trajet magnétique pour un champ magnétique perturbateur appliqué dans le deuxième sens horizontal (Y1-Y2) peut être formé entre les corps magnétiques doux (12) situés dans les corps élémentaires reliés (17) adjacents.

5. Le capteur magnétique (S) selon la revendication 4,
dans lequel la partie raccordement (12c) de l'un des corps magnétiques doux (12) situés dans les corps élémentaires reliés (17) adjacents est disposée sur une ligne de prolongement de la partie raccordement (12c) de l'autre corps magnétique doux.

6. Le capteur magnétique (S) selon l'une quelconque des revendications 2 à 4,
dans lequel une extrémité avant de la partie d'extrémité côté Y1 (12a) de l'un des corps magnétiques doux (12) qui sont situés des deux côtés de chaque partie d'élément (9) dans le deuxième sens horizontal (Y1-Y2) et une extrémité avant de la partie d'extrémité côté Y2 (12b) de l'autre corps magnétique doux (12) sont tournées vers la partie d'élément (9) dans une vue en plan, et
l'extrémité avant d'un corps magnétique doux (12) et l'extrémité avant de l'autre corps magnétique doux (12) se font face dans le deuxième sens horizontal (Y1-Y2) avec un écart (T2) entre les deux.

7. Le capteur magnétique (S) selon l'une quelconque des revendications 1 à 6,
dans lequel l'agencement de la partie d'élément (9), de la couche de polarisation (10) et du corps magnétique doux (12) est le même dans chaque corps élémentaire relié (17).

8. Le capteur magnétique (S) selon l'une quelconque des revendications 1 à 7,
dans lequel chaque corps élémentaire relié (17) comprend une première partie d'élément et une deuxième partie d'élément qui sont adjacentes l'une par rapport à l'autre dans le premier sens horizontal (X1-X2), et où la structure des couches de polarisation (10) qui sont situées des deux côtés de la première partie d'élément dans le premier sens horizontal (X1-X2) est différente de la structure des couches de polarisation (10) qui sont situées des deux côtés de la deuxième partie d'élément dans le premier sens horizontal (X1-X2) de telle sorte que le sens d'un premier champ magnétique de polarisation appliqué à la première partie d'élément est opposé au sens d'un deuxième champ magnétique de polarisation appliqué à la deuxième partie d'élément.

9. Le capteur magnétique (S) selon l'une quelconque des revendications 1 à 8,
dans lequel une zone de formation d'éléments à effet magnétorésistif est divisée en quatre zones dans le premier sens horizontal (X1-X2) et le deuxième sens horizontal (Y1-Y2),
un premier élément à effet magnétorésistif (1), un deuxième élément à effet magnétorésistif (2), un troisième élément à effet magnétorésistif (3) et un quatrième élément à effet magnétorésistif (4), chacun comprenant la partie d'élément (9), la couche de polarisation (10) et le corps magnétique doux (12) et formant un circuit en pont, sont formés dans les quatre zones, respectivement,
une modification dans la résistance électrique par rapport au champ magnétique externe appliqué dans le premier sens horizontal (X1-X2) est la même dans le premier élément à effet magnétorésistif (1) et le quatrième élément à effet magnétorésistif (4),
la modification dans la résistance électrique par rapport au champ magnétique externe appliqué dans le premier sens horizontal (X1-X2) est la même dans le deuxième élément à effet magnétorésistif (2) et le troisième élément à effet magnétorésistif (3), et est différente dans le premier élément à effet magnétorésistif (1) et le quatrième élément à effet magnétorésistif (4),
la structure de chaque partie d'élément (9) et de chaque couche de polarisation (10) est la même dans les éléments à effet magnétorésistif (1, 2, 3, 4),
les corps magnétiques doux (12) dans le premier élément à effet magnétorésistif (1) et le quatrième élément à effet magnétorésistif (4) ont la même structure,
les corps magnétiques doux (12) dans le deuxième élément à effet magnétorésistif (2) et le troisième élément à effet magnétorésistif (3) ont la même structure, et
les corps magnétiques doux (12) dans le premier élément à effet magnétorésistif (1) et le quatrième élément à effet magnétorésistif (4) sont différents les uns des autres, de telle sorte que le sens de conversion du champ magnétique appliqué à chaque partie d'élément dans le premier élément à effet magnétorésistif (1) est opposé à celui du champ magnétique appliqué à chaque partie d'élément dans le quatrième élément à effet magnétorésistif (4).

**10.** Le capteur magnétique (S) selon la revendication 9,
dans lequel les corps magnétiques doux (12) formant le premier élément à effet magnétorésistif (1) et le quatrième élément à effet magnétorésistif (4) et les corps magnétiques doux (12) formant le deuxième élément à effet magnétorésistif (2) et le troisième élément à effet magnétorésistif (3) sont symétriques par rapport à une ligne le long du deuxième sens horizontal (Y1-Y2).

**11.** Capteur magnétique (S) selon l'une quelconque des revendications précédentes, comprenant :
chaque corps magnétique doux (12) est configuré de telle sorte qu'un trajet magnétique pour un champ magnétique perturbateur appliqué dans le deuxième sens horizontal (Y1-Y2) peut être formé entre les corps magnétiques doux situés dans les corps élémentaires reliés (17) adjacents.

# FIG. 1

*FIG. 2*

FIG. 3

FIG. 4

## FIG. 5

## FIG. 6

## FIG. 7A

## FIG. 7B

## FIG. 7C

# FIG. 8

## FIG. 9

## FIG. 10

# FIG. 11

*FIG. 12*

## FIG. 13

## FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010259257 A1
- JP 7325138 A
- JP 9105630 A
- JP 7324933 A
- JP 7324934 A